# EUROPÄISCHE PATENTSCHRIFT

(11) **EP 3 257 086 B1**
(45) Veröffentlichungstag und Bekanntmachung des Hinweises auf die Patenterteilung: **05.12.2018**
(21) Anmeldenummer: 16705027.7
(22) Anmeldetag: 02.02.2016
(51) Int. Cl.: H01L 31/18, H01L 31/05

(54) **VERFAHREN UND VORRICHTUNG ZUR HERSTELLUNG VON SOLARZELLSTRÄNGEN**
METHOD AND DEVICE FOR PRODUCING SOLAR CELL STRANDS
PROCÉDÉ ET DISPOSITIF DE PRODUCTION DE LIGNES DE CELLULES SOLAIRES

(30) Priorität: 11.02.2015 DE 102015101973
(43) Veröffentlichungstag der Anmeldung: 20.12.2017
(73) Patentinhaber: M10 Industries AG, 79111 Freiburg im Breisgau (DE)
(72) Erfinder: SCHNEIDEREIT, Günter, 79112 Freiburg (DE); REDDEMANN, Gregor, 79199 Kirchzarten (DE)
(74) Vertreter: Börjes-Pestalozza, Henrich
(86) Internationale Anmeldenummer: PCT/EP2016/000163
(87) Internationale Veröffentlichungsnummer: WO 2016/128116

(56) Entgegenhaltungen:
- EP-A1- 2 299 500
- WO-A1-96/17387
- WO-A2-2012/016103
- CN-A- 103 182 579
- CN-A- 103 199 155
- US-A1- 2003 127 124
- US-A1- 2007 294 883

## Beschreibung

Die Erfindung betrifft ein Verfahren zur Herstellung von Solarzellsträngen, wobei elektrisch leitfähige Bändchen an einer einen Vorrat an Bändchen aufweisenden Abgabestation abgegeben und wenigstens einem Strang unverbundener Solarzellen zugeführt werden, wonach die Bändchen mit den Solarzellen des Strangs zu einem fertigen Solarzellstrang verbunden werden, wobei die Bändchen an wenigstens zwei jeweils einen Vorrat an Bändchenmaterial aufweisenden AbgabeStationen zur Abgabe bereitgehalten werden, wobei wenigstens ein Bändchen an zumindest einer der wenigstens zwei Abgabestationen automatisiert abgegeben wird, wobei die Abgabestation, von der das wenigstens eine Bändchen abgegeben wird, in Abhängigkeit eines in dieser Abgabestation verbliebenen oder vorhandenen Vorrats an Bändchenmaterial ausgewählt wird und wobei spätestens nach vollständigem Verbrauch des Vorrats der Abgabestation auf die wenigstens eine andere Abgabestation gewechseltwird.
Die Erfindung betrifft ferner eine Vorrichtung:zur Herstellung von Solarzellsträngen, bestehend aus mittels elektrisch leitenden Bändchen miteinander verbundenen Solarzellen, mit einer Abgabestation für elektrisch leitende Bändchen und mit einer Solarzellstrangauflage : zur Aufnahme und Bereithaltung wenigstens eines Strangs unverbundener Solarzellen und mit einer Verbindungsstation, in der die elektrisch leitenden Bändchen mit den Solarzellen verbindbar sind, wobei die Vorrichtung neben der einen wenigstens eine weitere Abgabestation und wenigstens eine Transportvorrichtung zur Aufnahme und zum Transport wenigstens eines Bändchens von zumindest einer der wenigstens zwei Abgabestationen zu der Solarzellstrangauflage aufweist.
Eine Fertigung von Solarzellsträngen, die dann in Solarmodulen verbaut werden können, nach einem derartigen Verfahren ist beispielsweise aus EP 2 299 500 A1, CN 103 199 155 A sowie CN 103 182 579 A bekannt. Dabei kann eine eingangs beschriebene Vorrichtung zur Herstellung von Solarzellsträngen zum Einsatz kommen. Vorrichtungendieser Art sind ebenfalls aus EP 2 299 500 A1, CN 103 199 155 A sowie CN 103 182 579 A vorbekannt. Weiterer druckschriftlicher Stand der Technik, der auf dem technischen Gebiet der auch automatisierten Herstellung von Solarzellsträngen angesiedelt ist, findet sich in den Druckschriften US 2007/0294 883 A1, US 2003/0127124 A1, WO 96/17387 A1 sowie WO 2012/016103 A2, die unterschiedliche Verfahren und Vorrichtungen zur Herstellung von Solarzellen betreffen.
Ein gewisses Problem kann bei den bekannten Verfahren und Vorrichtungen darin bestehen, dass der Herstellungsprozess der Solarzellstränge unterbrochen werden muss, wenn ein Vorrat an Bändchen, insbesondere eine Vorratsrolle, auf der die Bändchen zur Abgabe bereitgehalten werden,: verbraucht ist und durch eine neue Vorratsrolle ersetzt werden muss.
Aufgabe der Erfindung ist es daher, ein Verfahren und eine Vorrichtung der eingangs genannten Art zu schaffen, bei denen derartige Betriebsunterbrechungen verkürzt oder gar vermieden werden können.
Zur Lösung dieser Aufgabe sind bei dem eingangs definierten Verfahren die Merkmale des Patentanspruchs 1 vorgesehen. Insbesondere wird die Aufgabe dadurch gelöst, dass die Bändchen an wenigstens zwei jeweils einen Vorrat an Bändchenmaterial aufweisenden Abgabestationen zur Abgabe bereitgehalten werden und dass wenigstens ein Bändchen an zumindest einer der wenigstens zwei Abgabestationen automatisiert abgegeben wird. Dabei wird die Abgabestation, von der das wenigstenseine Bändchen abgegeben wird, in Abhängigkeit eines in dieser Abgabestation verbliebenen oder vorhandenen Vorrats an Bändchenmaterial ausgewählt. Spätestens nach vollständigem: Verbrauch des Vorrats der ausgewählten Abgabestation wird dann auf die wenigstens eine andere Abgabestationgewechselt. Auf diese Weise können die Bändchen zunächst an einer Abgabestation so lange abgenommen werden, bis ein Vorrat, insbesondere eine Vorratsrolle, dieser Abgabestation verbraucht ist. Da in dem Augenblick, in dem eine Vorratsrolle verbraucht ist, die Bändchen von der wenigstens zweiten Abgabestation abgegeben beziehungsweise von dieser abgenommen werden, können verbrauchsbedingte Betriebsunterbrechungen, wie sie bei den aus dem Stand der Technik bekannten Verfahren und Vorrichtungen notwendig sind, reduziert oder gar vermieden werden. Erfindungsgemäß ist vorgesehen, dass wenigstens ein Bändchen von zumindest einer der wenigstens zwei Abgabestationen automatisiert abgegeben und auf einer Transportvorrichtung, insbesondere auf einem verfahrbaren Transportschlittenträger, abgelegt wird. Dann wird die Transportvorrichtung zur: Aufnahme wenigstens eines Bändchens in eine einer der wenigstens zwei Abgabestationen zugeordneten Aufnahmeposition bewegt, vorzugsweise verfahren. Nachdem die Transportvorrichtung die jeweilige Aufnahmeposition erreicht hat, wird wenigstens ein Bändchen auf der Transportvorrichtung abgelegt. Nach Aufnahme wenigstens eines Bändchens wird die Transportvorrichtung dann in eine Abgabeposition benachbart zu der Solärzellsträngauflage für den wenigstens einen, mit Bändchen zu bestückenden Strang unverbundener Solarzellen bewegt. Nachdem die Transportvorrichtung ihre Abgabeposition erreicht hat, wird das wenigstens eine Bändchen von der Transportvorrichtung, vorzugsweise automatisiert, abgenommen und den Solarzellen zugeführt.
Selbstverständlich können zwei oder mehr Transportvorrichtungen bei dem Verfahren zum Einsatz kommen, falls zu erzielende Taktzeiten dies erfordern.
Dabei kann es zweckmäßig sein, wenn wenigstens ein Bändchen auf wenigstens einer an der Transportvorrichtung ausgebildeten Transportaufnahme abgelegt wird. Die wenigstens eine Transportaufnahme kann dabei als Element oder Teil der Transportvorrichtung verstanden werden. Auf diese Weise kann das wenigstens eine Bändchen auf der wenigstens einen Transportaufnahme mit der erforderlichenPräzision transportiert und den bereitgehaltenen Solarzellen zugeführt werden.
Vorteilhaft kann es sein, wenn die Transportvorrichtung und/odereine, beispielsweise die zuvor erwähnte, Transportaufnahme sequenziell und/oder in vorbestimmter Reihenfolge in die den wenigstens zwei Abgabestationen zugeordneten Aufnahmepositionen zur Aufnahme wenigstens eines Bändchens bewegt, insbesondere verfahren, wird/werden. Auf diese Weise ist es möglich, die wenigstens zwei Abgabestationen mit der Transportvorrichtung bzw. mit der wenigstens einen, an dieser vorgesehenen Transportaufnahme in einer vordefinierten Reihenfolge, beispielsweise in Abhängigkeit eines in den Abgabestationen verbliebenen Vorrats an Bändchenmaterial, anzufahren und Bändchen abzunehmen.

Bei einer Ausführungsform des Verfahrens kann vorgesehen sein, dass die wenigstens eine Transportaufnahme der Transportvorrichtung als Transportschlitten ausgebildet ist und an einem in Förderrichtung der Bändchen bewegbaren Transportschlittenträger der Transportvorrichtung quer zur Förderrichtung der Bändchen verfahren wird, um in die Aufnahmepositionen der wenigstens zwei Abgabestationen zu gelangen und dort eine erforderliche Anzahl von Bändchen aufzunehmen.

Besonders vorteilhaft kann es dabei sein, wenn eine Route oder ein Verfahrweg der Transportvorrichtung und/oder einer, beispielsweise der bereits zuvor erwähnten wenigstens einen, Transportaufnahme zwischen den wenigstens zwei Aufnahmepositionen und der Abgabeposition in Abhängigkeit zumindest eines definierten Parameters, insbesondere in Abhängigkeit eines Vorrats an Bändchenmaterial in den wenigstens zwei Abgabestationen, bestimmt wird. Dabei können die Route und/oder der Verfahrweg der Transportvorrichtung und/oder der wenigstens einen Transportaufnahme der Transportvorrichtung so bestimmt werden, dass ein Vorrat an Bändchenmaterial einer Abgabestation durch Abgabe von Bändchen an die Transportvorrichtung bzw. an die wenigstens eine Transportaufnahme vor einem Vorrat der wenigstens einen anderen Abgabestation ganz oder teilweise aufgebraucht wird.

Auf diese Weise kann sichergestellt werden, dass die wenigstens zwei Abgabestationen nicht zur gleichen Zeit leer gezogen werden und dass zudem in zumindest einer der wenigstens zwei Abgabestationen ein ausreichend großer Vorrat verbleibt, der es ermöglicht, eine leergefahrene oder leergezogene Abgabestation mit neuem Bändchenmaterial zu bestücken, ohne dass der Fertigungsprozess unterbrochen werden müsste.

Dabei kann vorgesehen sein, dass ein Vorrat an Bändchen in den wenigstens zwei Abgabestationen von einer Steuer- oder Regeleinheit, insbesondere mittels einer Überwachungsvorrichtung und/oder mittels eines Sensors, gemessen oder bestimmt wird und dass die Steuer- und/oder Regeleinheit ein von dem gemessenen oder bestimmten Vorrat der wenigstens zwei Abgabestationen abhängiges, den Verfahrweg und/oder die Route der Transportvorrichtung und/oder der Transportaufnahme vorgebendes Steuersignal an die Transportvorrichtung, insbesondere an eine Antriebsvorrichtung der Transportvorrichtung, abgibt. Auf diese Weise kann die zuvor beschriebene und vorrats- beziehungsweise verbrauchsabhängige Route der Transportvorrichtung bzw. der wenigstens einen Transportaufnahme automatisiert vorgegeben werden, indem der aktuelle Verbrauch und der verbliebene Vorrat in den wenigstens zwei Abgabestationen fortlaufend überwacht wird.

Es sei darauf hingewiesen, dass die zuvor erwähnte Antriebsvorrichtung der Transporteinrichtung, falls diese einen Transportschlittenträger und wenigstens eine als Transportschlitten ausgebildete Transportaufnahme aufweist, mit dem Transportschlitten und mit dem Transportschlittenträger derart verbunden sein kann, dass diese mithilfe der Antriebsvorrichtung in gewünschter Weise bewegt, insbesondere verfahren, werden können.

Wie zuvor beschrieben, kann es zweckmäßig sein, wenn die Bändchen an der Transportvorrichtung auf vordefinierten, an der Transportvorrichtung ausgebildeten Transportaufnahmen abgelegt werden. Dies kann eine genaue Abnahme und Übergabe der auf der Transportvorrichtung bereitgelegten Bändchen an eine nachgelagerte Station, insbesondere an die Solarzellstrangauflage, begünstigen.

Besonders zweckmäßig kann es sein, wenn eine Anzahl an Transportaufnahmen mit einer Anzahl gleichzeitig mit Bändchen zu bestückender Stränge unverbundener Solarzellen übereinstimmt. Somit ist es möglich, gleichzeitig Bändchen für sämtliche auf der Solarzellstrangauflage bereitgehaltenen Reihen oder Stränge unverbundener Solarzellen von der Transportvorrichtung abzunehmen und den Strängen zuzuführen, ohne die in Abgabeposition befindliche Transportvorrichtung nachpositionieren zu müssen.

Bei einer Ausführungsform des Verfahrens kann vorgesehen sein, dass die Transportvorrichtung und/oder die wenigstens eine Transportaufnahme an der Transportvorrichtung so bewegt oder verfahren wird/werden, dass die wenigstens eine Transportaufnahme an der Transportvorrichtung nacheinander in Aufnahmepositionen an den wenigstens zwei Abgabestationen gelangt. Falls mehr als eine Transportaufnahme an der Transportvorrichtung ausgebildet ist, können auf diese Weise die einzelnen, an der Transportvorrichtung vorgesehenen Transportaufnahmen für die Bändchen nacheinander mit Bändchen belegt und die Abgabestationen in einer bestimmten Reihenfolge angefahren werden. Zweckmäßig kann es außerdem sein, wenn je Abgabezyklus jeweils wenigstens ein Bändchen auf einer der mehreren Transportaufnahmen der Transportvorrichtung abgelegt wird.

Um das Verfahren vollautomatisiert durchzuführen, kann es außerdem zweckmäßig sein, wenn ein oder die auf der Transportvorrichtung abgelegtes Bändchen mittels einer Handhabungsvorrichtung von der in Abgabeposition bewegten Transportvorrichtung abgenommen und dem bereitgehaltenen Strang unverbundener Solarzellen zugeführt wird. Möglich ist aber auch, dass von jeder der Bändchen-Aufnahmen an der Transportvorrichtung wenigstens ein Bändchen mittels einer Handhabungsvorrichtung von der in Abgabeposition bewegten Transportvorrichtung abgenommen und jeweils einem bereitgehaltenen Strang unverbundener Solarzellen zugeführt wird. Möglich ist auch, dass mehrere Bändchen einem Strang unverbundener Solarzellen zugeführt werden.

Bei einer Ausführungsform des Verfahrens kann zudem vorgesehen sein, dass ein definiertes Stück Bändchenmaterial zur Herstellung eines Bändchens von einer Vorratsrolle mit Bändchenmaterial abgewickelt und nach dem Abwickeln in gewünschter Länge abgelängt wird, um ein Bändchen herzustellen, das dann in der zuvor beschriebenen Art und Weise an die Transportvorrichtung abgegeben werden kann.

Wie bereits zuvor angedeutet, können die Transportvorrichtung als Transportschlittenträger und die wenigstens eine Transportaufnahme als Transportschlitten ausgebildet sein. Auf diese Weise kann die wenigstens eine Transportaufnahme dann auf dem Transportschlittenträger verfahren werden, um die einzelnen Aufnahmepositionen der Abgabestationen zur Aufnahme wenigstens eines Bändchens anfahren zu können. Zusammen mit dem Transportschlittenträger kann dann die wenigstens eine mit wenigstens einem Bändchen bestückte Transportaufnahme von der Aufnahmeposition benachbart zu den Abgabestationen hin zu der Abgabeposition benachbart zu der Solarzellstrangauflage transportiert werden, um das wenigstens eine Bändchen an den wenigstens einen bereitgehaltenen Solarzellstrang abzugeben. Diese Transportbewegung kann dabeiin Förderrichtung der Bändchen aus den wenigstens zwei Abgabestationen erfolgen.
Zur Lösung der zuvor genannten Aufgabe wird auch eine Vorrichtung mit den Merkmalen des Patentanspruchs 7 vorgeschlagen. Die Aufgabe wird bei der eingangs definierten Vorrichtung insbesondere dadurch gelöst, dass die Vorrichtung neben der einen wenigstens eine weitere Abgabestation und wenigstens eine Transportvorrichtung zur Aufnahme und zum Transport wenigstens eines Bändchensvon zumindest einer der wenigstens zwei Abgabestationen zu der Solarzellstrangaufläge aufweist. Die wenigstens eine Transportvorrichtung kann dabei zwischen den wenigstens zwei Abgabestationen und der solarzeilstrangauflage angeordnet und zwischen diesen bewegbar, insbesondere verfahrbar sein. Auf diese Weise wird eine Vorrichtung geschaffen, die sich zur Durchführung des zuvor beschriebenen verfahrens eignet und mit der sich verbrauchsbedingte Ausfallzeiten der Vorrichtung vermeiden lassen können.
Erfindungsgemäß ist bei der Vorrichtung ferner vorgesehen, dass jeder der wenigstens zwei Abgabestationen jeweils eine Aufnahmeposition zugeordnet ist, in die die wenigstens eine Transportvorrichtung zur Aufnahme wenigstens eines von einer der wenigstens zwei Abgabestationen abgegebenen Bändchens bewegbar ist. Zudem kann vorgesehen sein, dass der Solarzellstrangauflage eine Abgabeposition zugeordnet ist, in die die wenigstens eine Transportvorrichtung zur Abgabe wenigstens eines Bändchens auf wenigstens einen auf der Solarzellstrangauflage bereitgehaltenen Strang unverbundener Solarzellen bewegbar ist. Auf diese Weise kann die ^{:}Transportvorrichtung zwischen vordefinierten Aufnahmepositionen und zumindest einer vordefinierten Abgabeposition bewegt werden, um die Bändchen in der zuvor beschriebenen Art und Weise. von den wenigstens zwei Abgabestationen zu der Solarzellstrangauflage zu transportieren.
Besonders zweckmäßig kann es sein, wenn die wenigstens eine Transportvorrichtung wenigstenseine Transportaufnahme aufweist, auf der wenigstens ein zu transportierendes Bändchen ablegbar ist.
Ferner kann vorgesehen sein, dass eine Anzahl von Transportaufnahmen einer Anzahl von, insbesondere nebeneinander angeordneten, Auflageplätzen für Stränge unverbundener Solarzellen an der Solarzellstrangauflage entspricht. Zudem kahn es vorteilhaft sein, wenn die Transportaufnahmen entsprechend einer Anordnung von Auflageplätzen für Stränge unverbundener Solarzellen an der Solariellstrarigallflage, insbesondere nebeneinander, anordenbar und/oder angeordnet sind, insbesondere bei in Abgabeposition befindlicher Transportvorrichtung.
Dies ermöglicht es, mit hoher Arbeitsgeschwindigkeit alle Solarzellstränge gleichzeitig mit Bändchen zu beschicken.
Dabei können die wenigstens eine Transportvorrichtung und/oder eine oder die wenigstens eine Transportaufnahme quer oder rechtwinklig zur Orientierung des wenigstens einen mit Bändchen zu bestückenden Strangs unverbundener Solarzellen und/oder quer oder rechtwinklig zur Förderrichtung der Bändchen aus den wenigstens zwei Abgabestationen, insbesondere zwischen den wenigstens zwei Abgabestationen zugeordneten Aufnahmepositionen, bewegbar sein, um die erforderlichen Transportbewegungen durchführen zu können.

Bei einer Ausführungsform der erfindungsgemäßen Vorrichtung von besonderer Bedeutung kann ferner vorgesehen sein, dass die wenigstens eine Transportvorrichtung einen Transportschlittenträger aufweist und dass die wenigstens eine Transportaufnahme der wenigstens einen Transportvorrichtung als Transportschlitten ausgebildet ist. Dabei kann vorgesehen sein, dass die wenigstens eine Transportaufnahme an dem Transportschlittenträger zwischen Aufnahmepositionen der Abgabestationen, insbesondere quer oder rechtwinklig zur Förderrichtung der Bändchen, verfahrbar angeordnet ist.

Zweckmäßig kann es sein, wenn der Transportschlittenträger in und entgegen der Förderrichtung der Bändchen zwischen den Abgabestationen und der Solarzellstrangauflage bewegbar ist. Die wenigstens eine als Transportschlitten ausgebildete Transportaufnahme kann quer bzw. rechtwinklig zur Förderrichtung zwischen den Aufnahmepositionen der Abgabestationen an dem Transportschlittenträger bewegt werden, um Bändchen von den Abgabestationen aufzunehmen. Die erforderlichen Bewegungen werden somit von zwei unabhängig voneinander und in unterschiedlichen Richtungen bewegbaren Elementen der Transportvorrichtung durchgeführt, wobei der Transportschlittenträger den Transportschlitten zusammen mit den aufgelegten Bändchen von den Abgabestationen zu der Solarzellstrangauflage transportieren kann.

Bei einer besonders zweckmäßigen Ausführungsform der Vorrichtung kann vorgesehen sein, dass eine, beispielsweise die bereits zuvor erwähnte wenigstens eine, Transportaufnahme der Transportvorrichtung bei in Abgabeposition befindlicher Transportvorrichtung in Fortsetzung, insbesondere in Längserstreckungsrichtung, eines auf der Solarzellstrangauflage bereitgehaltenen Strangs unverbundener Solarzellen ausgerichtet ist. Auf diese Weise kann die Transportvorrichtung in einer einfachen und linearen Bewegung zwischen den wenigstens zwei Abgabepositionen und der Solarzellstrangauflage hin- und her bewegt werden. Zudem können die Bändchen auf diese Weise sehr einfach von der jeweiligen Transportaufnahme an die Solarzellstrangauflage und den wenigstens einen, dort zur Beschickung bereitgehaltenen Strang unverbundener Solarzellen übergeben werden.

Außerdem kann vorgesehen sein, dass die Transportvorrichtung quer oder rechtwinklig zur Orientierung des wenigstens einen mit Bändchen zu bestückenden Strangs unverbundener Solarzellen und/oder quer oder rechtwinklig zur Förderrichtung der Bändchen, insbesondere zwischen den den wenigstens zwei Abgabestationen zugeordneten, Aufnahmepositionen bewegbar ist.

Um einen Verfahrweg oder eine Route der Transportvorrichtung, beispielsweise in Abhängigkeit des aktuellen Verbrauchs und/oder des in den wenigstens zwei Abgabestationen verbliebenen Vorrats an Bändchenmaterial, vorgeben zu können, ist es zweckmäßig, wenn die Vorrichtung eine Steuer- und/oder Regeleinheit aufweist. Diese kann zur Steuerung der wenigstens zwei Abgabestationen und/oder der Transportvorrichtung, insbesondere einer Antriebsvorrichtung für einen oder den Transportschlittenträger und/oder für eine oder die wenigstens eine Transportaufnahme der Transportvorrichtung, eingerichtet sein. Dadurch können die wenigstens zwei Abgabestationen und/oder die Transportvorrichtung mithilfe der Steuer- und/oder Regeleinheit ausgewählt und/oder gesteuert werden.

Zur Bestimmung eines Vorrats an Bändchenmaterial in den wenigstens zwei Abgabestationen kann es ferner zweckmäßig sein, wenn die Vorrichtung, insbesondere eine, beispielsweise die bereits zuvor erwähnte, Steuer- und/oder Regeleinheit, eine Überwachungsvorrichtung, vorzugsweise mit wenigstens einem Sensor, aufweist.

Zudem kann vorgesehen sein, dass die Vorrichtung, insbesondere die Steuer- und/oder Regeleinheit, zur Steuerung der Bewegungen der Transportvorrichtung und/oder einer, beispielsweise der bereits zuvor erwähnten wenigstens einen, Transportaufnahme in Abhängigkeit eines Verbrauchs eines Vorrats an Bändchen und/oder eines verbliebenen Restbestands an Bändchen in den wenigstens zwei Abgabestationen eingerichtet ist. Wie zuvor erwähnt, kann die Vorrichtung insbesondere zur Steuerung einer, beispielsweise der bereits zuvor erwähnten, Antriebsvorrichtung des Transportschlittenträgers und/oder der wenigstens einen Transportaufnahme der Transportvorrichtung, in Abhängigkeit eines Verbrauchs eines Vorrats an Bändchen und/oder eines verbliebenen Restbestands an Bändchen in den wenigstens zwei Abgabestationen eingerichtet sein.

Wenn die Vorrichtung, insbesondere die Steuer- und/oder Regeleinheit und/oder eine, beispielsweise die bereits zuvor erwähnte, Überwachungsvorrichtung, eine Zähleinrichtung aufweist, können der Verbrauch und ein in den wenigstens zwei Abgabestationen verbliebener Vorrat oder Restbestand an Bändchen auf einfache Weise bestimmt werden. Dabei kann die Zähleinrichtung zur Überwachung einer Anzahl von ausgegebenen Bändchen und/oder eines Vorrats an Bändchen der wenigstens zwei Abgabestationen eingerichtet sein.

Mit Hilfe der Zähleinrichtung kann dann vermieden werden, dass der Vorrat an Bändchenmaterial in den wenigstens zwei Abgabestationen gleichzeitig aufgebraucht ist. Die Zähleinrichtung kann dabei eine Zahl von Abgabevorgängen beziehungsweise von Verfahrschritten der Transportvorrichtung feststellen und diese Information dann an die Steuer- und/oder der Regeleinheit der Vorrichtung übertragen, die dann in Abhängigkeit des so zumindest mittelbar festgestellten Restvorrats die Route beziehungsweise den Verfahrweg der Transportvorrichtung vorgeben kann.

Eine weitere zweckmäßige Ausgestaltung der Erfindung für eine möglichst lange Arbeitsweise ohne Unterbrechung kann vorsehen, dass jede der wenigstens zwei Abgabestationen zumindest eine, vorzugsweise jedoch zwei, drei, vier oder fünf oder mehr Vorratsrollen an Bändchenmaterial aufweist.

Wenn jede der wenigstens zwei Abgabestationen mehrere Vorratsrollen enthält, ist es möglich, dass auf jeden Fall ununterbrochen Bändchen von den Abgabestationen geliefert werden können und bei Verbrauch einer Rolle andere Abgabestationen und/oder Vorratsrollen dennoch weiterhin ausreichend viele Bändchen abgeben können.

Zudem kann vorgesehen sein, dass die Vorrichtung wenigstens eine Ablängstation mit einer Schneidvorrichtung zum Ablängen elektrisch leitender Bändchen von auf einer Vorratsrölle aufgerolltem Bändchenmaterial aufweist. Bevorzugt kann jeder der wenigstens zwei Abgabestationen jeweils eine Ablängstation mit einer Schneidvorrichtung zum Ablängen elektrisch leitender Bändchen von auf einer Vorratsrolle aufgerolltem Bändchenmaterial zugeordnet sein. Auf diese Weise können die Bändchen in gewünschter Länge von dem aufgerollten Bändchenmaterial, das quasi als Endlosstrang vorliegt, abgelängt und anschließend auf die Transportvorrichtung beziehungsweise den Transportschlittenträger abgegeben werden.

Zur Übergabe von Bändchen von der in Abgabeposition befindlichen Transportvorrichtung an den wenigstens einen auf der Solarzellstrangauflage bereitgehaltenen Strang unverbundener Solarzellen kann die Vorrichtung eine Handhabungseinheit aufweisen. Diese Handhabungseinheit kann insbesondere als Greifer, Schieber und/oder auch als Saugeinrichtung ausgebildet sein.

Ferner kann vorgesehen sein, dass die wenigstens zwei Abgabestationen und die Solarzellstrangauflage in Förderrichtung der Bändchen und/oder in Erstreckungsrichtung des wenigstens einen Strangs unverbundener Solarzellen einen Abstand zueinander aufweisen. Dabei kann der Abstand zwischen den wenigstens zwei Abgabestationen und der Solarzellstrangauflage durch eine Bewegung der Transportvorrichtung aus einer der Ausnahmepositionen in die Abgabeposition, insbesondere in Förderrichtung der Bändchen und/oder in Erstreckungsrichtung des wenigstens einen Strangs unverbundener Solarzellen, überbrückbar sein. Bei einer anderen Ausführungsform der Erfindung kann zusätzlich oder alternativ dazu auch vorgesehen sein, dass dieser Abstand zwischen den wenigstens zwei Abgabestationen und der Solarzellstrangauflage mittels einer, beispielsweise der bereits zuvor erwähnten, Handhabungseinheit überbrückbar ist.

Für eine besonderes ökonomische Durchführung des Herstellungsverfahrens kann die Solarzellstrangauflage an einer Transportvorrichtung, insbesondere an einem Förderband, ausgebildet sein, mit welcher Transportvorrichtung mit Bändchen bestückte Stränge von Solarzellen einer, beispielsweise der bereits zuvor erwähnten nachgelagerten Verbindungsstation der Vorrichtung zugeführt werden können. Auf diese Weise ist es also möglich, Solarzellen beziehungsweise Solarzellrohlinge auf die Solarzellstrangauflage aufzulegen und diese dann fortlaufend mit Bändchen zu beschicken, da mit Bändchen bestückte/beschickte Solarzellstränge mittels des Förderbandes simultan und fortlaufend der nachgelagerten Verbindungsstation, in der die Bändchen mit den Solarzellen verbunden werden, um den Solarzellstrang herzustellen, zugeführt werden können.

Bei einem Ausführungsbeispiel der Erfindung von besonderer Bedeutung kann vorgesehen sein, dass die Vorrichtung vier Abgabestationen mit jeweils einer Aufnahmeposition und zwei Transportvorrichtungen mit jeweils sechs Transportaufnahmen für jeweils wenigstens ein Bändchen aufweist. Bei diesem Ausführungsbeispiel der Erfindung kann außerdem vorgesehen sein, dass auf der Solarzellstrangauflage wenigstens zwei, insbesondere drei, vier, fünf, sechs, sieben, acht oder neun Auflageplätze für Stränge oder Reihen unverbundener Solarzellen vorgesehen sind, so dass gleichzeitig bis zu zwei, drei, vier, fünf, sechs, sieben, acht oder neun Stränge oder Reihen unverbundener Solarzellen auf der Solarzellstrangauflage anordenbar sind.

Selbstverständlich ist es auch denkbar, noch mehr Abgabestationen mit jeweils einer Aufnahmeposition und eine Solarzellstrangauflage, die mehr als neun Auflageplätze für Stränge zunächst unverbundener Solarzellen aufweist, vorzusehen. Die Anzahl von Abgabestationen beziehungsweise der Auflageplätzen für Stränge unverbundener Solarzellen richtet sich dabei nach der mit dieser Vorrichtung zu produzierenden Stückzahl von Solarzellsträngen pro Zeiteinheit.

Nachstehend ist ein Ausführungsbeispiel der Erfindung anhand der Zeichnung näher beschrieben. Es zeigt in stark schematisierter Darstellung:

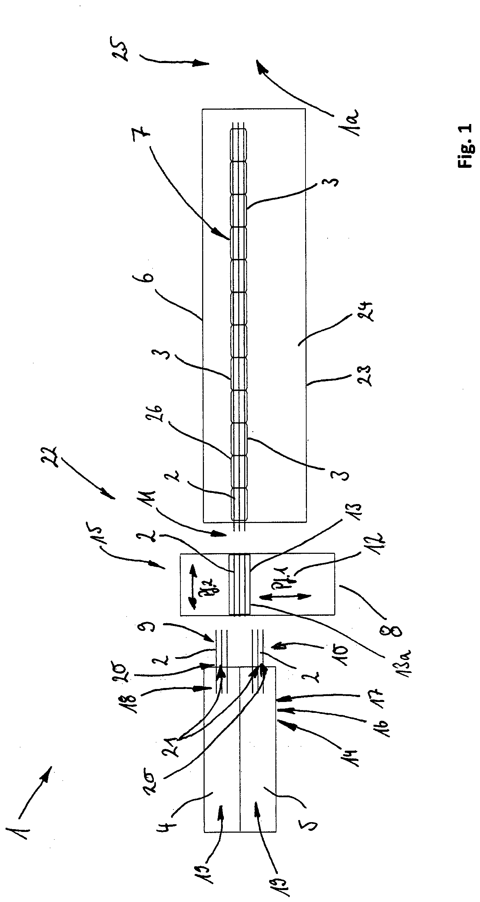

- Fig. 1:: Eine stark schematisierte Draufsicht auf eine erfindungsgemäße Vorrichtung zur Veranschaulichung des erfindungsgemäßen Herstellungsverfahrens.

Figur 1 zeigt eine im Ganzen mit 1 bezeichnete Vorrichtung zur Herstellung von Solarzellsträngen 1a bestehend aus mittels elektrisch leitenden Bändchen 2 miteinander verbundenen Solarzellen 3. Die Vorrichtung 1 weist zwei Abgabestationen 4 und 5 für elektrisch leitende Bändchen 2 und eine Solarzellstrangauflage 6 zur Aufnahme und Bereithaltung wenigstens eines Strangs 7 zunächst noch unverbundener Solarzellen 3 auf. Dieser Vorrichtung 1 zugehörig ist auch eine Verbindungsstation 25, in der die elektrisch leitenden Bändchen 2 mit den Solarzellen 3 verbunden und die Solarzellstränge 1a fertiggestellt werden können.

Neben den im vorliegenden Beispiel insgesamt zwei Abgabestationen 4 und 5 weist die Vorrichtung 1 zudem eine Transportvorrichtung 8 auf, die der Aufnahme und dem Transport wenigstens einen Bändchens 2 von zumindest einer der insgesamt zwei Abgabestationen 4 und 5 zu der Solarzellstrangauflage 6 dient. Jeder der zwei Abgabestationen 4 und 5 ist jeweils einer Aufnahmeposition 9 beziehungsweise 10 zugeordnet, in die die Transportvorrichtung 8 zur Aufnahme wenigstens eines von einer der beiden Abgabestationen 4 und 5 abgegebenen Bändchens 2 bewegbar ist. Im vorliegenden Ausführungsbeispiel geben die beiden Abgabestationen 4 und 5 jeweils drei Bändchen 2 gleichzeitig ab.

Bei in den Figuren nicht dargestellten Ausführungsformen der Vorrichtung 1 bzw. des Verfahrens ist vorgesehen, dass vier, fünf, sechs oder sieben oder mehr Bändchen 2 gleichzeitig von einer der Abgabestationen 4, 5 abgegeben und einem Strang 7 unverbundener Solarzellen 3 zugeführt werden.

Ferner ist der Solarzellstrangauflage 6 eine Abgabeposition 11 zugeordnet, in die die Transportvorrichtung 8 zur Abgabe wenigstens eines Bändchens 2 auf wenigstens einen auf der Solarzellstrangauflage 6 bereitgehaltenen Strang 7 unverbundener Solarzellen 3 bewegbar ist.

In Figur 1 ist zu erkennen, dass die Transportvorrichtung 8 einen zwischen den beiden Abgabestationen 4 und 5 und der Solarzellstrangauflage 6 verfahrbaren Transportschlittenträger 12 und zumindest eine Transportaufnahme 13 umfasst. Dabei können an der Transportvorrichtung 8 so viele Transportaufnahmen 13 wie Auflageplätze 26 an der Solarzellstrangaufnahme 6 vorgesehen sein. Auf diesen Auflageplätzen 26, von denen in Figur 1 nur einer belegt ist, können mehrere, gleichzeitig mit Bändchen 2 zu bestückende Stränge 7 unverbundener Solarzellen 3 nebeneinander angeordnet sein.

Figur 1 zeigt, dass im vorliegenden Ausführungsbeispiel der Vorrichtung 1 auf der einzigen Transportaufnahme 13 insgesamt drei Bändchen 2 abgelegt sind.

Gemäß Figur 1 wird deutlich, dass die Anordnung und Ausrichtung der Transportaufnahme 13 an der Transportvorrichtung 8 der Anordnung und Ausrichtung des im vorliegenden Beispiel einzigen Strangs 7 von unverbundenen Solarzellen 3, der auf dem Auflageplatz 26 an der Solarzellstrangaufnahme 6 aufgelegt ist, entspricht.

Figur 1 zeigt auch, dass die Transportaufnahme 13 der Transportvorrichtung 8 bei in Abgabeposition 11 befindlicher Transportvorrichtung 8 in Fortsetzung und in Längserstreckungsrichtung des auf der Solarzellstrangauflage 6 bereitgehaltenen Strangs 7 unverbundener Solarzellen 3 fluchtend zu dem Strang 7 ausgerichtet ist.

Die beiden Doppelpfeile Pf.1 und Pf.2 verdeutlichen die Bewegungen, die die Transportvorrichtung 8 und ihre beweglichen Bestandteile, nämlich der Transportschlittenträger 12 und die Transportaufnahme 13, während des Betriebs der Vorrichtung 1 ausführen können. Dabei kann die Transportvorrichtung 8 als Ganzes und insbesondere der Transportschlittenträger 12 in Richtung des Doppelpfeiles Pf.2 verschoben werden, um die Bändchen 2 von den Abgabestationen 4, 5 zu der Solarzellstrangauflage 6 zu transportieren.

Die Transportaufnahme 13 ist im vorliegenden Fall als Transportschlitten 13a ausgebildet, der in beide Richtungen des Doppelpfeiles Pf. 1 relativ zu und auf der Transportvorrichtung 8 verfahren werden kann, um in die Aufnahmepositionen 9, 10 vor den beiden Abgabestationen 4, 5 zu gelangen.

Die Transportvorrichtung 8 weist, wie zuvor beschrieben, den Transportschlittenträger 12 auf, der die Transportaufnahme 13 trägt, dieser als Führungsschiene dient und sich über die gesamte Breite quer vor den Abgabestationen 4 und 5 der Vorrichtung 1 erstreckt.

Die als Transportschlitten 13a ausgebildete Transportaufnahme 13 wird auf dem Transportschlittenträger 12 rechtwinklig zur Orientierung des wenigstens einen mit Bändchen 2 zu bestückenden Strangs 7 unverbundener Solarzellen 3 und damit auch quer und rechtwinklig zur Förderrichtung der Bändchen 2 zwischen den beiden Abgabestationen 4 und 5 zugeordneten Aufnahmepositionen 9 und 10 bewegt, um Bändchen 2 von den beiden Abgabestationen 4, 5 aufzunehmen.

Auch wenn mehr als nur eine Transportaufnahme 13 an der Transportvorrichtung 8 vorgesehen ist, können die mehreren Transportaufnahmen 13, die in diesem Ausführungsbeispiel allesamt als Transportschlitten 13a ausgebildet sind, auf dem Transportschlittenträger 12 der Transportvorrichtung 8 in beide Richtungen des Doppelpfeiles Pf.1 bewegt werden, um die einzelnen Abgabestationen 4,5 zur Aufnahme von Bändchen 2 in mit einer vorbestimmten Route oder Reihenfolge anzufahren.

Die Vorrichtung 1 weist zudem eine Steuer- und/oder Regeleinheit 14 auf, die zur Steuerung der beiden Abgabestationen 4 und 5 und der Transportvorrichtung 8, insbesondere einer Antriebsvorrichtung 15 für die Transportvorrichtung 8 eingerichtet ist. Mit der Steuer- und/oder Regeleinheit 14 können die beiden Abgabestationen 4, 5 ausgewählt und gesteuert sowie die Transportvorrichtung 8 mitsamt ihrer Bestandteile, nämlich dem Transportschlittenträger 12 und der Transportaufnahme 13, gesteuert werden.

Die Antriebsvorrichtung 15 ist dabei sowohl zum Antrieb des Transportschlittenträgers 12 als auch der als Transportschlitten 13a ausgebildeten Transportaufnahme 13 der Transportvorrichtung 8 eingerichtet und mit diesen verbunden.

Die Steuer- und/oder Regeleinheit 14 umfasst zudem eine Überwachungsvorrichtung 16, die wenigstens einen Sensor 17 aufweist. Die Überwachungsvorrichtung dient einer Bestimmung eines Vorrats an Bändchenmaterial in den beiden Abgabestationen 4, 5. Dabei ist die Vorrichtung 1 mit Hilfe der Steuer- und/oder Regeleinheit 14 zur Steuerung der Bewegungen der Transportvorrichtung 8, insbesondere zur Steuerung der Antriebsvorrichtung 15 der Transportvorrichtung 8, in Abhängigkeit von dem Verbrauch eines Vorrats an Bändchen 2 in den beiden Abgabestationen 4, 5 eingerichtet.

Die Vorrichtung 1 weist zudem eine Zähleinrichtung 18 zum Bestimmen des Verbrauchs und des in den beiden Abgabestationen 4, 5 verbliebenen Vorrats an Bändchen 2 bzw. Bändchenmaterial auf. Dabei ist die Zähleinrichtung 18 zur Überwachung einer Anzahl von ausgegebenen Bändchen 2 und eines Vorrats an Bändchen 2 der beiden Abgabestationen 4, 5 eingerichtet.

Jede der beiden Abgabestationen 4, 5 ist mit einer Mehrzahl von Vorratsrollen 19 mit Bändchenmaterial ausgestattet, so dass der Herstellungsprozess über einen langen Zeitraum ohne Unterbrechungen ablaufen kann.

Um elektrisch leitende Bändchen 2 von auf den Vorratsrollen 19 aufgerollten Bändchenmaterial ablängen zu können, weist die Vorrichtung 1, insbesondere jede der beiden Abgabestationen 4, 5 jeweils eine Ablängstation 20 mit einer Schneidvorrichtung 21 auf.

Die Vorrichtung 1 ist zur Übergabe von Bändchen 2 von der in Abgabeposition 11 befindlichen Transportaufnahme 13 und/oder Transportvorrichtung 8 an den wenigstens einen auf der Solarzellstrangauflage 6 bereitgehaltenen Strang 7 unverbundener Solarzellen 3 mit einer Handhabungseinheit 22 ausgerüstet. Dabei kann diese Handhabungseinheit 22 als Greifer, Schieber oder aber auch als Saugeinrichtung ausgebildet sein.

Die beiden Abgabestationen 4 und 5 und die Solarzellstrangauflage 6 weisen in Förderrichtung der Bändchen und in Erstreckungsrichtung des wenigstens einen Stranges 7 unverbundener Solarzellen 3 einen Abstand zueinander auf. Dieser Abstand zwischen den beiden Abgabestationen 4 und 5 und der Solarzellstrangauflage 6 kann durch eine Bewegung der Transportvorrichtung 8 aus einer der Aufnahmepositionen 9 oder 10 in die Abgabeposition 11, also in Förderrichtung der Bändchen 2 und in Erstreckungsrichtung des wenigstens einen Stranges 7 unverbundener Solarzellen 3 überbrückt werden. Diese Bewegung ist anhand des Pfeiles Pf.2 veranschaulicht.

Ein verbleibender Restabstand zwischen den beiden Abgabestationen 4 und 5 und der Solarzellstrangauflage 6 bzw. zwischen der Transportvorrichtung 8 in Abgabeposition 11 und der Solarzellstrangauflage 6 kann mittels der Handhabungseinheit 22 überbrückt werden.

Die Solarzellstrangauflage 6 ist an einer als Förderband 23 ausgebildeten Transporteinrichtung 24 angeordnet, mit welcher mit Bändchen 2 bestückte Stränge 7 von Solarzellen 3 einer nachgelagerten Verbindungsstation 25 der Vorrichtung 1 zugeführt werden können.

Auf der zuvor beschriebenen Vorrichtung 1 kann nachfolgend beschriebenes Verfahrens durchgeführt werden.

Dabei ist vorgesehen, dass bei dem Verfahren zur Herstellung von Solarzellsträngen die elektrisch leitfähigen Bändchen 2 an den beiden Abgabestationen 4, 5 abgegeben werden. Jede der beiden Abgabestationen 4, 5 weist einen Vorrat an Bändchen 2 auf. Die Bändchen 2 werden wenigstens einem Strang 7 unverbundener Solarzellen 3 zugeführt, wonach die Bändchen 2 mit den Solarzellen 3 des Strangs 7 zu einem fertigen Solarzellstrang 1a verbunden werden.

Dabei werden die Bändchen 2 an wenigstens zwei, jeweils einen Vorrat an Bändchenmaterial aufweisenden Abgabestationen 4, 5 zur Abgabe bereitgehalten. Wenigstens ein Bändchen 2, hier jedoch drei gleichzeitig, wird dann an zumindest einer der im vorliegenden Ausführungsbeispiel insgesamt zwei Abgabestationen, 4, 5 automatisiert abgegeben, wobei die Abgabestation 4 oder 5, von der das wenigstens eine Bändchen 2 abgegeben wird, in Abhängigkeit eines in dieser Abgabestation 4, 5 verbliebenen oder vorhanden Vorrats an Bändchenmaterial ausgewählt wird. Dabei wird spätestens nach vollständigem Verbrauch des Vorrats an Bändchenmaterial der Abgabestation 4 oder 5 auf die wenigstens eine andere Abgabestation 4 oder 5 gewechselt.

Hier werden insgesamt drei Bändchen 2 gleichzeitig von zumindest einer der beiden Abgabestationen 4, 5 automatisiert abgegeben und auf der Transportvorrichtung 8, die den verfahrbaren Transportschlittenträger 12 und die eine Transportaufnahme 13 umfasst, abgelegt.

Dabei wird die Transportvorrichtung gemeinsam mit dem Transportschlittenträger 12 und der Transportaufnahme 13 zur Aufnahme der Bändchen 2 in die der jeweiligen Abgabestation 4, 5 zugeordneten Aufnahmeposition 9 beziehungsweise 10 bewegt, im vorliegenden Fall verfahren. Nachdem die jeweilige Aufnahmeposition 9 beziehungsweise 10 erreicht ist, wird wenigstens ein Bändchen 2, im vorliegenden Fall insgesamt drei Bändchen 2, auf der Transportvorrichtung 8 abgelegt. Nach Aufnahme der drei Bändchen 2 wird die Transportvorrichtung 8 in die Abgabeposition 11 benachbart zu dem mit Bändchen 2 zu bestückenden Strang 7 unverbundener Solarzellen 3 bewegt. Sobald die Transportvorrichtung 8 ihre Abgabeposition 11 erreicht hat, werden die Bändchen 2 von der Transportvorrichtung 8 abgenommen und den Solarzellen 3 zugeführt.

Dabei kann die Transportvorrichtung 8 mit der Transportaufnahme 13 sequenziell und/oder in vorbestimmter Reihenfolge in die den beiden Abgabestationen 4, 5 zugeordneten Aufnahmepositionen 8, 9 zur Aufnahme einer gewünschten Anzahl von Bändchen 2 bewegt, insbesondere verfahren, werden.

Eine Route oder ein Verfahrweg der Transportvorrichtung 8 zwischen den zwei Aufnahmepositionen 9 und 10 und der Abgabeposition 11 wird in Abhängigkeit zumindest eines definierten Parameters, insbesondere in Abhängigkeit eines vorhandenen Vorrats an Bändchenmaterial in den beiden Abgabestationen 4, 5 bestimmt. Dabei kann die Route beziehungsweise der Verfahrweg der Transportvorrichtung 8 so bestimmt werden, dass ein Vorrat an Bändchenmaterial einer Abgabestation 4, 5 durch Abgabe von Bändchen 2 an die Transportvorrichtung 8 vor einem Vorrat der anderen Abgabestation 4, 5 ganz oder teilweise aufgebraucht wird.

Dabei können der Transportschlittenträger 12 in beide Richtungen des Doppelpfeiles Pf.2 und die als Transportschlitten 13a ausgebildete Transportaufnahme 13 in beide Richtungen des Doppelpfeiles Pf.1 bewegt werden.

Der Vorrat an Bändchenmaterial beziehungsweise Bändchen 2 in den beiden Abgabestationen 4, 5 wird dabei von der Steuer- und/oder Regeleinheit 14 und hier insbesondere mittels der Überwachungsvorrichtung 16 gemessen oder bestimmt. Zu diesem Zweck weist die Überwachungsvorrichtung 16 zumindest einen bereits zuvor beschriebenen Sensor 17 auf.

Die Steuer- und/oder Regeleinheit 14 überträgt ein von dem gemessenen oder bestimmten Vorrat der beiden Abgabestationen 4, 5 abhängiges, dem Verfahrweg und/oder die Route der Transportvorrichtung 8 vorgebendes Steuersignal an die Transportvorrichtung 8. Mit Hilfe dieses Steuersignals können dann die Antriebsvorrichtung 15 der Transportvorrichtung 8 entsprechend gesteuert und die als Transportschlitten 13a ausgebildete Transportaufnahme 13 und der Transportschlittenträger 12 entsprechend bewegt werden.

Die Bändchen 2 werden an der Transportvorrichtung 8 auf den vordefinierten, an der Transportvorrichtung 8 ausgebildeten Transportaufnahmen 13 abgelegt.

Dabei kann die Anzahl von Transportaufnahmen 13 mit einer Anzahl gleichzeitig mit Bändchen 2 zu bestückender Stränge 7 unverbundener Solarzellen 3 übereinstimmen. Im vorliegenden Ausführungsbeispiel sind eine Transportaufnahme 13 und ein Strang 7 unverbundener Solarzellen 3 auf der Solarzellstrangauflage 6 vorgesehen.

Bei einem nicht dargestellten Ausführungsbeispiel ist jedoch vorgesehen, dass an einer, insbesondere als Transportschlitten 13a ausgebildeten, Transportaufnahme 13 Ablageplätze für Bändchen 2 von mehreren Strängen 7 angeordnet sind.

Die Transportvorrichtung 8 beziehungsweise der Transportschlittenträger 12 und die als Transportschlitten 13a ausgebildete Transportaufnahme 13 werden dabei so bewegt beziehungsweise verfahren, dass die Transportaufnahme 13 an der Transportvorrichtung 8 nacheinander in die Aufnahmepositionen 9 und 10 an den beiden Abgabestationen 4, 5 gelangt. Dabei kann die an der Transportvorrichtung 8 ausgebildete Transportaufnahme 13 vollständig von einer Abgabestation 4 oder 5 bestückt werden oder aber einen Teil der Bändchen 2 von der einen Abgabestation 4, 5 und einen anderen Teil beziehungsweise den Rest der Bändchen 2 von der jeweils anderen Abgabestation 4, 5 erhalten.

Wenn mehrere Transportaufnahmen 13 an der Transportvorrichtung 8 ausgebildet sind, kann vorgesehen sein, dass je Abgabezyklus wenigstens ein Bändchen 2 auf wenigstens einer der Transportaufnahmen 13 der Transportvorrichtung 8 abgelegt wird.

Es sei an dieser Stelle nochmals betont, dass mehrere Transportaufnahmen 13, insbesondere wenn sie als Transportschlitten 13a ausgebildet sind, unabhängig voneinander auf dem Transportschlittenträger 12 in beide Richtungen des Doppelpfeiles Pf. 1 verfahrbar sind, um die einzelnen Abgabestationen 4, 5, in vorbestimmter Reihenfolge anzufahren und Bändchen aufzunehmen.

Bei einer Ausführungsform des Verfahrens ist vorgesehen, das ein auf der Transportvorrichtung 8 abgelegtes Bändchen 2 mittels der zuvor beschriebenen Handhabungsvorrichtung 22 von der in Abgabeposition 11 bewegten Transportvorrichtung 8 abgenommen und dem bereitgehaltenen Solarzellstrang 7 zugeführt wird.

Um die Bändchen 2 in vorbestimmter Länge mittels der beiden Abgabestationen 4 und 5 an die Transportvorrichtung 8 abgeben zu können, ist vorgesehen, dass ein definiertes Stück Bändchenmaterial zur Herstellung eines Bändchens 2 von einer der Vorratsrollen 19 mit Bändchenmaterial automatisiert abgewickelt und nach dem Abwickeln automatisiert abgelängt wird.

Zur Herstellung von Solarzellsträngen 1a ist vorgesehen, dass elektrisch leitfähige Bändchen 2 an den einen Vorrat an Bändchen 2 aufweisenden Abgabestationen 4, 5 abgegeben und wenigstens einem Strang 7 unverbundener Solarzellen 3 zugeführt werden. Dazu werden die Bändchen 2 an wenigstens zwei jeweils einen Vorrat an Bändchenmaterial aufweisenden Abgabestationen 4, 5 zur Abgabe bereitgehalten. Wenigstens ein Bändchen 2 wird dann an zumindest einer der wenigstens zwei Abgabestationen 4, 5 automatisiert abgegeben, wobei die Abgabestation 4, 5, von der das wenigstens eine Bändchen 2 abgegeben wird, in Abhängigkeit eines in dieser Abgabestation 4, 5 verbliebenen oder vorhandenen Vorrats an Bändchenmaterial ausgewählt wird und wobei spätestens nach vollständigem Verbrauch des Vorrats der Abgabestation 4, 5 auf die wenigstens eine andere Abgabestation 4, 5 gewechselt wird.

## Patentansprüche

1. Verfahren zur Herstellung von Solarzellsträngen, wobei elektrisch leitfähige Bändchen (2) an einer einen Vorrat an Bändchen (2) aufweisenden Abgabestation (4, 5) abgegeben und wenigstens einem Strang (7) unverbundener Solarzellen (3) zugeführt werden, wonach die Bändchen (2) mit den Solarzellen (3) des Strangs (7) zu einem fertigen Solarzellstrang (1a) verbunden werden, wobei die Bändchen (2) an wenigstens zwei jeweils einen Vorrat an Bändchenmaterial aufweisenden Abgabestationen (4, 5) zur Abgabe bereitgehalten werden, wobei wenigstens ein Bändchen (2) an zumindest einer der wenigstens zwei Abgabestationen (4, 5) automatisiert abgegeben wird, wobei die Abgabestation (4, 5), von der das wenigstens eine Bändchen (2) abgegeben wird, in Abhängigkeit eines in dieser Abgabestation (4, 5) verbliebenen oder vorhandenen Vorrats an Bändchenmaterial ausgewählt wird und wobei spätestens nach vollständigem Verbrauch des Vorrats der Abgabestation (4, 5) auf die wenigstens eine andere Abgabestation (4, 5) gewechselt wird, wobei wenigstens ein Bändchen (2) von zumindest einer der wenigstens zwei Abgabestationen (4, 5) automatisiert abgegeben und auf einer Transportvorrichtung (8) abgelegt wird, wobei die Transportvorrichtung (8) zur Aufnahme wenigstens eines Bändchens (2) in eine einer der wenigstens zwei Abgabestationen (4, 5) zugeordneten Aufnahmeposition (9, 10) bewegt wird, dass wenigstens ein Bändchen (2) auf der Transportvorrichtung (8) abgelegt wird, nachdem diese die jeweilige Aufnahmeposition (9, 10) erreicht hat, und dass die Transportvorrichtung (8) nach Aufnahme wenigstens eines Bändchens (2) in eine Abgabeposition (9, 10) benachbart zu einer Solarzellstrangauflage (6) für den wenigstens einen, mit Bändchen (2) zu bestückenden Strang (7) unverbundener Solarzellen (3) bewegt wird und dass das wenigstens eine Bändchen (2) von der Transportvorrichtung (8) abgenommen und den Solarzellen (3) zugeführt wird, nachdem die Transportvorrichtung (8) ihre Abgabeposition (9, 10) erreicht hat.

2. Verfahren nach Anspruch 1, **dadurch gekennzeichnet, dass** wenigstens ein Bändchen (2) auf wenigstens einer an der Transportvorrichtung (8) ausgebildeten Transportaufnahme (13) abgelegt wird.

3. Verfahren nach Anspruch 1 oder 2, **dadurch gekennzeichnet, dass** die Transportvorrichtung (8) in vorbestimmter Reihenfolge in die den wenigstens zwei Abgabestationen (4, 5) zugeordneten Aufnahmepositionen (8, 9) zur Aufnahme wenigstens eines Bändchens (2) bewegt, insbesondere verfahren, wird/werden, insbesondere wobei die wenigstens eine Transportaufnahme (13) als Transportschlitten (13a) ausgebildet ist und an einem zwischen den Abgabestationen (4,5) und einer oder der Solarzellstrangauflage (6) bewegbaren Transportschlittenträger (12) der Transportvorrichtung (8) quer zur Förderrichtung der Bändchen (2) verfahren wird, um in die Abgabepositionen (9,10) der wenigstens zwei Abgabestationen (4,5) zu gelangen.

4. Verfahren nach einem der vorhergehenden Ansprüche, **dadurch gekennzeichnet, dass** eine Route oder ein Verfahrweg der Transportvorrichtung (8) zwischen den wenigstens zwei Aufnahmepositionen (9, 10) und der Abgabeposition (11) in Abhängigkeit zumindest eines definierten Parameters, insbesondere in Abhängigkeit eines Vorrats an Bändchenmaterial in den wenigstens zwei Abgabestationen (4, 5), bestimmt wird und dass die Route oder der Verfahrweg der Transportvorrichtung (8) so bestimmt wird, dass ein Vorrat an Bändchenmaterial einer Abgabestation (4, 5) durch Abgabe von Bändchen an die Transportvorrichtung (8) vor einem Vorrat der wenigstens einen anderen Abgabestation ganz oder teilweise aufgebraucht wird.

5. Verfahren nach einem der vorhergehenden Ansprüche, **dadurch gekennzeichnet, dass** ein Vorrat an Bändchen (2) in den wenigstens zwei Abgabestationen (4, 5) von einer Steuer- und/oder Regeleinheit (14), insbesondere mittels einer Überwachungsvorrichtung (16), gemessen oder bestimmt wird und dass die Steuer- und/oder Regeleinheit (14) ein von dem gemessenen oder bestimmten Vorrat der wenigstens zwei Abgabestationen (4, 5) abhängiges, den Verfahrweg oder die Route der wenigstens einen Transportvorrichtung (8) vorgebendes Steuersignal an die Transportvorrichtung (8), insbesondere an eine Antriebsvorrichtung (15) der Transportvorrichtung (8), abgibt.

6. Verfahren nach einem der vorhergehenden Ansprüche, **dadurch gekennzeichnet, dass** die wenigstens eine Transportvorrichtung (8) so bewegt oder verfahren werden, dass eine oder die wenigstens eine Transportaufnahme (13) für Bändchen (2) an der Transportvorrichtung (8) nacheinander in Aufnahmepositionen (9, 10) an den wenigstens zwei Abgabestationen (4, 5) gelangt, wobei je Abgabezyklus wenigstens ein Bändchen (2) auf wenigstens eine der Transportaufnahmen (13) der Transportvorrichtung (8) abgelegt wird.

7. Vorrichtung (1) zur Herstellung von Solarzellsträngen (1a) bestehend aus mittels elektrisch leitenden Bändchen (2) miteinander verbundenen Solarzellen (3), mit einer Abgabestation (4, 5) für elektrisch leitende Bändchen (2) und mit einer Solarzellstrangauflage (6) zur Aufnahme und Bereithaltung wenigstens eines Strangs (7) unverbundener Solarzellen (3) und mit einer Verbindungsstation (25), in der die elektrisch leitenden Bändchen (2) mit den Solarzellen (3) verbindbar sind, wobei die Vorrichtung (1) neben der einen wenigstens eine weitere Abgabestation (4, 5) und wenigstens eine Transportvorrichtung (8) zur Aufnahme und zum Transport wenigstens eines Bändchens (2) von zumindest einer der wenigstens zwei Abgabestationen (4, 5) zu der Solarzellstrangauflage (6) aufweist, wobei jeder der wenigstens zwei Abgabestationen (4, 5) jeweils eine Aufnahmeposition (9, 10) zugeordnet ist, in die die wenigstens eine Transportvorrichtung (8) zur Aufnahme wenigstens eines von einer der wenigstens zwei Abgabestationen (4, 5) abgegebenen Bändchens (2) bewegbar ist, und dass der Solarzellstrangauflage (6) eine Abgabeposition (11) zugeordnet ist, in die die wenigstens eine Transportvorrichtung (8) zur Abgabe wenigstens eines Bändchens (2) auf wenigstens einen auf der Solarzellstrangauflage (6) bereitgehaltenen Strang (7) unverbundener Solarzellen (8) bewegbar (Pf.2) ist.

8. Vorrichtung nach Anspruch 7, **dadurch gekennzeichnet, dass** die wenigstens eine Transportvorrichtung (8) wenigstens eine Transportaufnahme (13) aufweist, auf der wenigstens ein zu transportierendes Bändchen (2) ablegbar ist.

9. Vorrichtung (1) nach einem der vorhergehenden Ansprüche, **dadurch gekennzeichnet, dass** eine Anzahl von Transportaufnahmen (13) einer Anzahl von, insbesondere nebeneinander angeordneten, Auflageplätzen (26) für Stränge (7) unverbundener Solarzellen (3) an der Solarzellstrangauflage (6) entspricht und/oder dass die Transportaufnahmen (13) entsprechend einer Anordnung von Auflageplätzen (26) für Stränge (7) unverbundener Solarzellen (3) an der Solarzellstrangauflage (6), insbesondere nebeneinander, anordenbar oder angeordnet sind, insbesondere bei in Abgabeposition (11) befindlicher Transportvorrichtung (8).

10. Vorrichtung (1) nach einem der vorhergehenden Ansprüche, **dadurch gekennzeichnet, dass** die wenigstens eine Transportvorrichtung (8) einen Transportschlittenträger (12) aufweist und dass die wenigstens eine Transportaufnahme (13) der Transportvorrichtung (8) als Transportschlitten (13a) ausgebildet ist, wobei die wenigstens eine Transportaufnahme (13) an dem Transportschlittenträger (12) zwischen Aufnahmepositionen (9, 10) der Abgabestationen (4,5), insbesondere quer oder rechtwinklig zur Förderrichtung der Bändchen (2), verfahrbar (Pf.1) angeordnet ist.

11. Vorrichtung (1) nach einem der vorhergehenden Ansprüche, **dadurch gekennzeichnet, dass** die Vorrichtung (1) eine Steuer- und/oder Regeleinheit (14) aufweist, die zur Steuerung der wenigstens zwei Abgabestationen (4, 5) eingerichtet ist, wobei mit der Steuer- und/oder Regeleinheit (14) die wenigstens zwei Abgabestationen (4, 5) auswählbar und steuerbar sind, und/oder dass die Vorrichtung (1) die oder eine Steuer- und/oder Regeleinheit (14) aufweist, die zur Steuerung der Transportvorrichtung (8) eingerichtet ist.

12. Vorrichtung (1) nach einem der vorhergehenden Ansprüche, **dadurch gekennzeichnet, dass** die Vorrichtung (1), insbesondere eine oder die Steuer- und/oder Regeleinheit (14), eine Überwachungsvorrichtung (16), insbesondere mit wenigstens einem Sensor (17), zur Bestimmung eines Vorrats an Bändchenmaterial in den wenigstens zwei Abgabestationen (4, 5) aufweist und/oder dass die Vorrichtung (1), insbesondere die Steuer- und/oder Regeleinheit (14), zur Steuerung der Bewegungen der wenigstens einen Transportvorrichtung (8) in Abhängigkeit eines Restbestandes an Bändchen (2) und/oder eines Verbrauchs eines Vorrats an Bändchen (2) in den wenigstens zwei Abgabestationen (4, 5) eingerichtet ist.

13. Vorrichtung nach einem der vorhergehenden Ansprüche, **dadurch gekennzeichnet, dass** die Vorrichtung (1) eine Handhabungseinheit (22) aufweist, die zur Übergabe von Bändchen (2) von der in Abgabeposition (11) befindlichen Transportvorrichtung (8) an den wenigstens einen auf der Solarzellstrangauflage (6) bereitgehaltenen Strang (7) unverbundener Solarzellen (3) vorgesehen ist.

14. Vorrichtung (1) nach einem der vorhergehenden Ansprüche, **dadurch gekennzeichnet, dass** die wenigstens zwei Abgabestationen (4, 5) und die Solarzellstrangauflage (6) in Förderrichtung der Bändchen (2) und/oder in Erstreckungsrichtung des wenigstens einen Stranges (7) unverbundener Solarzellen (3) einen Abstand zueinander aufweisen, wobei der Abstand zwischen den wenigstens zwei Abgabestationen (4, 5) und der Solarzellstrangauflage (6) durch eine Bewegung der Transportvorrichtung (8) aus einer der Aufnahmepositionen (9, 10) in die Abgabeposition (11) und/oder mittels einer oder der Handhabungseinheit (22) überbrückbar ist.

15. Vorrichtung (1) nach einem der vorhergehenden Ansprüche, **dadurch gekennzeichnet, dass** die Solarzellstrangauflage (6) an einer Transporteinrichtung (24), insbesondere an einem Förderband (23), ausgebildet ist, mit welcher Transporteinrichtung mit Bändchen (2) bestückte Stränge (7) von Solarzellen (3) einer oder der nachgelagerten Verbindungsstation (25) der Vorrichtung (1) zuführbar sind.

## Claims

1. Method for producing solar cell strings, wherein electrically conductive ribbons (2) are dispensed at a dispensing station (4, 5) that has a reserve of ribbons (2), and fed to at least one string (7) of unconnected solar cells (3), whereupon the ribbons (2) are connected to the solar cells (3) of the string (7) so as to form a finished solar cell string (1a), wherein the ribbons (2) are kept ready for dispensing on at least two dispensing stations (4, 5) that each have a reserve of ribbon material, wherein at least one ribbon (2) is dispensed in an automated manner on at least one of the at least two dispensing stations (4, 5), wherein the dispensing station (4, 5) from which the at least one ribbon (2) is dispensed is selected depending on a reserve of ribbon material that remains or exists in that dispensing station (4, 5), and wherein switching to the at least one other dispensing station (4, 5) takes place at the latest upon complete consumption of the reserve of the dispensing station (4, 5), **wherein** at least one ribbon (2) is dispensed in an automated manner from at least one of the at least two dispensing stations (4, 5) and is deposited on a transportation device (8), wherein the transportation device (8) for receiving at least one ribbon (2) is moved to a receiving position (9, 10) that is assigned to one of the at least two dispensing stations (4, 5), in that at least one ribbon (2) is deposited on the transportation device (8) once the latter has reached the respective receiving position (9, 10), and in that the transportation device (8) upon receiving at least one ribbon (2) is moved to a dispensing position (9, 10) that is adjacent to a solar cell string bearing (6) for the at least one string (7) of unconnected solar cells (3) that is to be equipped with ribbons (2), and in that the at least one ribbon (2) is retrieved from the transportation device (8) and fed to the solar cells (3) once the transportation device (8) has reached the dispensing position (9, 10) thereof.

2. Method according to Claim 1, **characterized in that** at least one ribbon (2) is deposited on at least one transportation receptacle (13) that is configured on the transportation device (8).

3. Method according to Claim 1 or 2, **characterized in that** the transportation device (8) for receiving at least one ribbon (2) are/is moved, in particular displaced, in a predetermined sequence to the receiving positions (8, 9) that are assigned to the at least two dispensing stations (4, 5), wherein in particular the at least one transportation receptacle (13) is configured as a transportation slide (13a) and on a transportation slide carrier (12) of the transportation device (8) that is movable between the dispensing stations (4, 5) and a or the solar cell string bearing (6) is displaced transversely to the conveying direction of the ribbons (2), so as to reach the dispensing positions (9, 10) of the at least two dispensing stations (4, 5) .

4. Method according to one of the preceding claims, **characterized in that** a route or a displacement path of the transportation device (8) between the at least two receiving positions (9, 10) and the dispensing position (11) is determined depending on at least one defined parameter, in particular depending on a reserve of ribbon material in the at least two dispensing stations (4, 5), and **in that** the route or the displacement path of the transportation device (8) is determined such that a reserve of ribbon material of one dispensing station (4, 5), by dispensing ribbons to the transportation device (8), is entirely or partially consumed before a reserve of the at least one other dispensing station.

5. Method according to one of the preceding claims, **characterized in that** a reserve of ribbons (2) in the at least two dispensing stations (4, 5) is measured or determined by a controller and/or regulator unit (14), in particular by means of a monitoring device (16), and **in that** the controller and/or regulator unit (14) emits a control signal to the transportation device (8), in particular to a drive device (15) of the transportation device (8), said control signal depending on the measured or determined reserve of the at least two dispensing stations (4, 5) and predefining the displacement path or the route of the at least one transportation device (8).

6. Method according to one of the preceding claims, **characterized in that** the at least one transportation device (8) is moved or displaced such that a or the at least one transportation receptacle (13) for ribbons (2) on the transportation device (8) sequentially reaches the receiving positions (9, 10) on the at least two dispensing stations (4, 5), wherein at least one ribbon (2) is deposited on at least one of the transportation receptacles (13) of the transportation device (8) per dispensing cycle.

7. Device (1) for producing solar cell strings (1a) composed of solar cells (3) that are interconnected by means of electrically conducting ribbons (2), having a dispensing station (4, 5) for electrically conducting ribbons (2), and having a solar cell bearing (6) for receiving and keeping ready at least one string (7) of unconnected solar cells (3), and having a connection station (25) in which the electrically conducting ribbons (2) are connectable to the solar cells (3), wherein the device (1) apart from the one has at least one further dispensing station (4, 5) and at least one transportation device (8) for receiving and transporting at least one ribbon (2) from at least one of the at least two dispensing stations (4, 5) to the solar cell string bearing (6), **wherein** each of the at least two dispensing stations (4, 5) in each case is assigned one receiving position (9, 10) to which the at least one transportation device (8) is movable for receiving at least one ribbon (2) that is dispensed from one of the at least two dispensing stations (4, 5), and in that the solar cell string bearing (6) is assigned a dispensing position (11) to which the at least one transportation device (8) is movable (arrow Pf. 2) for dispensing at least one ribbon (2) on at least one string (7) of unconnected solar cells (8) that is kept ready on the solar cell string bearing (6).

8. Device according to Claim 7, **characterized in that** the at least one transportation device (8) has at least one transportation receptacle (13) on which at least one ribbon (2) to be transported is depositable.

9. Device (1) according to one of the preceding claims, **characterized in that** a number of transportation receptacles (13) corresponds to a number of bearing places (26), in particular disposed beside one another, for strings (7) of unconnected solar cells (3) on the solar cell string bearing (6), and/or **in that** the transportation receptacles (13) are disposable or disposed, in particular beside one another, so as to correspond to an arrangement of bearing places (26) for strings (7) of unconnected solar cells (3) on the solar cell string bearing (6), in particular in the case of a transportation device (8) that is located in the dispensing position (11).

10. Device (1) according to one of the preceding claims, **characterized in that** the at least one transportation device (8) has a transportation slide carrier (12), and **in that** the at least one transportation receptacle (13) of the transportation device (8) is configured as a transportation slide (13a), wherein the at least one transportation receptacle (13) on the transportation slide carrier (12) is disposed between receiving positions (9, 10) of the dispensing stations (4, 5), in particular so as to be displaceable (arrow 1) transversely or orthogonally to the conveying direction of the ribbons (2).

11. Device (1) according to one of the preceding claims, **characterized in that** the device (1) has a controller and/or regulator unit (14) which is adapted for controlling the at least two dispensing stations (4, 5), wherein the at least two dispensing stations (4, 5) are selectable and controllable, and/or **in that** the device (1) has the or a controller and/or regulator unit (14) which is adapted for controlling the transportation device (8), by way of the controller and/or regulator unit (14).

12. Device (1) according to one of the preceding claims, **characterized in that** the device (1), in particular a or the controller and/or regulator unit (14), has a monitoring device (16), in particular having at least one sensor (17), for determining a reserve of ribbon material in the at least two dispensing stations (4, 5), and/or **in that** the device (1), in particular the controller and/or regulator unit (14), is adapted for controlling the movements of the at least one transportation device (8), depending on a residual stock of ribbons (2) and/or on a consumption of a reserve of ribbons (2) in the at least two dispensing stations (4, 5).

13. Device according to one of the preceding claims, **characterized in that** the device (1) has a handling unit (22) which is provided for transferring ribbons (2) from the transportation device (8) that is located in the dispensing position (11) to the at least one string (7) of unconnected solar cells (3) that is kept ready on the solar cell string bearing (6) .

14. Device (1) according to one of the preceding claims, **characterized in that** the at least two dispensing stations (4, 5) and the solar cell string bearing (6) in the conveying direction of the ribbons (2) and/or in the direction of extent of the at least one string (7) of unconnected solar cells (3) have a mutual spacing, wherein the spacing between the at least two dispensing stations (4, 5) and the solar cell string bearing (6) is capable of being bridged by a movement of the transportation device (8) from one of the receiving positions (9, 10) to the dispensing position (11), and/or by means of a or the handling unit (22).

15. Device (1) according to one of the preceding claims, **characterized in that** the solar cell string bearing (6) is configured on a transportation installation (24), in particular on a conveyor belt (23), by way of which transportation installation strings (7) of solar cells (3) that are equipped with ribbons (2) are feedable to a or the downstream connection station (25) of the device (1).

## Revendications

1. Procédé de production de lignes de cellules solaires, dans lequel des bandelettes électriquement conductrices (2) sont distribuées à une station de distribution (4, 5) présentant un stock de bandelettes (2) et sont fournies à au moins une ligne (7) de cellules solaires non reliées (3), puis les bandelettes (2) sont connectées aux cellules solaires (3) de la ligne (7) en une ligne de cellules solaires terminée (1a), dans lequel on prépare les bandelettes pour la distribution à au moins deux stations de distribution (4, 5) présentant respectivement un stock de matériau de bandelettes, dans lequel on distribue de manière automatisée au moins une bandelette (2) à au moins une des deux stations de distribution (4, 5), dans lequel on choisit la station de distribution (4, 5), à partir de laquelle on distribue ladite au moins une bandelette (2), en fonction d'un stock de matériau de bandelettes resté ou présent dans cette station de distribution (4, 5) et dans lequel on commute sur ladite au moins une autre station de distribution (4, 5) au plus tard après consommation totale du stock de la station de distribution (4, 5), dans lequel on distribue de façon automatisée au moins une bandelette (2) à partir d'au moins une desdites au moins deux stations de distribution (4, 5) et on la dépose sur un dispositif de transport (8), dans lequel on déplace le dispositif de transport (8) destiné à recevoir au moins une bandelette (2) dans une position de réception (9, 10) associée à une desdites au moins deux stations de distribution (4, 5), dans lequel on dépose au moins une bandelette (2) sur le dispositif de transport (8) après que celui-ci ait atteint la position de réception respective (9, 10), et dans lequel on déplace le dispositif de transport (8) après réception d'au moins une bandelette (2) dans une position de distribution (9, 10) proche d'un dépôt de lignes de cellules solaires (6) pour ladite au moins une ligne (7) de cellules solaires non reliées (3) à équiper de bandelettes (2) et dans lequel on enlève ladite au moins une bandelette (2) du dispositif de transport (8) et on la fournit aux cellules solaires (3), après que le dispositif de transport (8) a atteint sa position de distribution (9, 10).

2. Procédé selon la revendication 1, **caractérisé en ce que** l'on dépose au moins une bandelette (2) sur au moins un logement de transport (13) formé sur le dispositif de transport (8).

3. Procédé selon la revendication 1 ou 2, **caractérisé en ce que** l'on meut, en particulier on déplace, le dispositif de transport (8) dans un ordre prédéterminé dans les positions de réception (8, 9) associées auxdites au moins deux stations de distribution (4, 5) pour le logement d'au moins une bandelette (2), en particulier dans lequel ledit au moins un logement de transport (13) est formé par un chariot de transport (13a) et est déplacé sur un support de chariot de transport (12) du dispositif de transport (8) mobile entre les stations de distribution (4, 5) et un ou le dépôt de lignes de cellules solaires (6) transversalement à la direction de transport des bandelettes (2), pour arriver dans les positions de distribution (9, 10) desdites au moins deux stations de distribution (4, 5).

4. Procédé selon l'une quelconque des revendications précédentes, **caractérisé en ce que** l'on détermine une route ou un itinéraire du dispositif de transport (8) entre lesdites au moins deux positions de réception (9, 10) et la position de distribution (11) en fonction d'au moins un paramètre défini, en particulier en fonction d'un stock de matériau de bandelettes dans lesdites au moins deux stations de distribution (4, 5), et **en ce que** l'on détermine la route ou l'itinéraire du dispositif de transport (8) de telle manière qu'un stock de matériau de bandelettes d'une station de distribution (4, 5) soit entièrement ou partiellement consommé par distribution de bandelettes au dispositif de transport (8) avant un stock de ladite au moins une autre station de distribution.

5. Procédé selon l'une quelconque des revendications précédentes, **caractérisé en ce que** l'on mesure ou on détermine un stock de bandelettes (2) dans lesdites au moins deux stations de distribution (4, 5) au moyen d'une unité de commande et/ou de régulation (14), en particulier au moyen d'un dispositif de surveillance (16), et **en ce que** l'unité de commande et/ou de régulation (14) envoie un signal de commande dépendant du stock mesuré ou déterminé desdites au moins deux stations de distribution (4, 5) et prédéterminant l'itinéraire ou la route dudit au moins un dispositif de transport (8) au dispositif de transport (8), en particulier à un dispositif d'entraînement (15) du dispositif de transport (8).

6. Procédé selon l'une quelconque des revendications précédentes, **caractérisé en ce que** l'on meut ou l'on déplace ledit au moins un dispositif de transport (8) de telle manière qu'un ou ledit au moins un logement de transport (13) pour des bandelettes (2) sur le dispositif de transport (8) arrive successivement dans des positions de réception (9, 10) auxdites au moins deux stations de distribution (4, 5), dans lequel on dépose au moins une bandelette (2) sur au moins un des logements de transport (13) du dispositif de transport (8) par cycle de distribution.

7. Dispositif (1) de production de lignes de cellules solaires (1a) se composant de cellules solaires (3) reliées l'une à l'autre au moyen de bandelettes électriquement conductrices (2), avec une station de distribution (4, 5) pour des bandelettes électriquement conductrices (2) et avec un dépôt de lignes de cellules solaires (6) destiné à recevoir et à préparer au moins une ligne (7) de cellules solaires non reliées (3) et avec une station de connexion (25), dans laquelle les bandelettes électriquement conductrices (2) peuvent être connectées aux cellules solaires (3), dans lequel le dispositif (1) présente en plus de ladite une au moins une autre station de distribution (4, 5) et au moins un dispositif de transport (8) pour la réception et le transport d'au moins une bandelette (2) depuis au moins une desdites au moins deux stations de distribution (4, 5) jusqu'au dépôt de lignes de cellules solaires (6), dans lequel une position de réception (9, 10) est respectivement associée à chacune desdites au moins deux stations de distribution (4, 5), dans laquelle ledit au moins un dispositif de transport (8) est déplaçable pour recevoir au moins une bandelette (2) distribuée par une desdites au moins deux stations de distribution (4, 5), et en ce qu'une position de distribution (11) est associée au dépôt de lignes de cellules solaires (6), dans laquelle ledit au moins un dispositif de transport (8) est déplaçable pour distribuer au moins une bandelette (2) sur au moins une ligne (7) de cellules solaires non reliées (8) préparée sur le dépôt de lignes de cellules solaires (6) (Flèche 2).

8. Dispositif selon la revendication 7, **caractérisé en ce que** ledit au moins un dispositif de transport (8) présente au moins un logement de transport (13), sur lequel au moins une bandelette à transporter (2) peut être déposée.

9. Dispositif (1) selon l'une quelconque des revendications précédentes, **caractérisé en ce qu'**un nombre de logements de transport (13) correspond à un nombre d'emplacements de dépôt (26), en particulier disposés l'un à côté de l'autre, pour des lignes (7) de cellules solaires non reliées (3) sur le dépôt de lignes de cellules solaires (6) et/ou **en ce que** les logements de transport (13) peuvent être ou sont disposés selon un agencement, en particulier l'un à côté de l'autre, d'emplacements de dépôt (26) pour des lignes (7) de cellules solaires non reliées (3) sur le dépôt de lignes de cellules solaires (6), en particulier lorsque le dispositif de transport (8) se trouve dans la position de distribution (11).

10. Dispositif (1) selon l'une quelconque des revendications précédentes, **caractérisé en ce que** ledit au moins un dispositif de transport (8) présente un support de chariot de transport (12) et **en ce que** ledit au moins un logement de transport (13) du dispositif de transport (8) est réalisé sous forme de chariot de transport (13a), dans lequel ledit au moins un logement de transport (13) est disposé de façon déplaçable dans le support de chariot de transport (12) entre des positions de réception (9, 10) des stations de distribution (4, 5), en particulier transversalement ou perpendiculairement à la direction de transport des bandelettes (2) (Flèche 1).

11. Dispositif (1) selon l'une quelconque des revendications précédentes, **caractérisé en ce que** le dispositif (1) présente une unité de commande et/ou de régulation (14), qui est configurée pour la commande desdites au moins deux stations de distribution (4, 5), dans lequel lesdites au moins deux stations de distribution (4, 5) peuvent être sélectionnées et commandées avec l'unité de commande et/ou de régulation (14), et/ou **en ce que** le dispositif (1) présente l'unité de commande et/ou de régulation (14), qui est configurée pour la commande du dispositif de transport (8).

12. Dispositif (1) selon l'une quelconque des revendications précédentes, **caractérisé en ce que** le dispositif (1), en particulier une unité de commande et/ou de régulation (14), présente un dispositif de surveillance (16), en particulier avec au moins un capteur (17), pour la détermination d'un stock de matériau de bandelettes dans lesdites au moins deux stations de distribution (4, 5), et/ou **en ce que** le dispositif (1), en particulier l'unité de commande et/ou de régulation (14), est configuré pour la commande des mouvements dudit au moins un dispositif de transport (8) en fonction d'une quantité résiduelle de bandelettes (2) et/ou d'une consommation d'un stock de bandelettes (2) dans lesdites au moins deux stations de distribution (4, 5).

13. Dispositif selon l'une quelconque des revendications précédentes, **caractérisé en ce que** le dispositif (1) présente une unité de manipulation (22), qui est prévue pour le transfert de bandelettes (2) du dispositif de transport (8) se trouvant dans la position de distribution (11) à ladite au moins une ligne (7) de cellules solaires non reliées (3) préparée sur le dépôt de lignes de cellules solaires (6).

14. Dispositif (1) selon l'une quelconque des revendications précédentes, **caractérisé en ce que** lesdites au moins deux stations de distribution (4, 5) et le dépôt de lignes de cellules solaires (6) présentent une distance l'un de l'autre dans la direction de transport des bandelettes (2) et/ou dans la direction d'extension de ladite au moins une ligne (7) de cellules solaires non reliées (3), dans lequel la distance entre lesdites au moins deux stations de distribution (4, 5) et le dépôt de lignes de cellules solaires (6) peut être comblée par un mouvement du dispositif de transport (8) depuis une des positions de réception (9, 10) jusqu'à la position de distribution (11) et/ou au moyen d'une ou de l'unité de manipulation (22).

15. Dispositif (1) selon l'une quelconque des revendications précédentes, **caractérisé en ce que** le dépôt de lignes de cellules solaires (6) est formé sur un système de transport (24), en particulier sur une bande transporteuse (23), système de transport avec lequel des lignes (7) de cellules solaires (3) équipées de bandelettes (2) peuvent être fournies à une ou à la station de connexion suivante (25) du dispositif (1).
